# EUROPEAN PATENT APPLICATION

(11) **EP 4 546 962 A1**
(43) Date of publication of application: **30.04.2025**
(21) Application number: 24202985.8
(22) Date of filing: 26.09.2024
(51) Int. Cl.: H05K 7/14, H05K 7/20

(54) **COOLING STRUCTURE FOR ELECTRONIC COMPONENT AND VEHICLE DRIVING DEVICE CROSS REFERENCE**

(30) Priority: 27.10.2023 JP 2023184660; 31.01.2024 JP 2024012705
(71) Applicant: Aisin Corporation, Aichi 448-8650 (JP)
(72) Inventor: TAKEMOTO, Keisuke, Kariya, 448-8650 (JP); MUTSUURA, Keita, Kariya, 448-8650 (JP); SUGIMOTO, Noriaki, Kariya, 448-8650 (JP); GOTO, Kenta, Kariya, 448-8650 (JP); HANAMURA, Takuya, Kariya, 448-8650 (JP); HAGITA, Kazuhiro, Kariya, 448-8650 (JP)
(74) Representative: Kramer Barske Schmidtchen Patentanwälte PartG mbB

(57) **Abstract**

In an electronic component cooling structure in which a plurality of cooling plates (11, 12) each having a cooling fluid flow path (R) therein is disposed, cooling fluid for cooling an electronic components (15, 16, 21, 22, 66, T) flowing through the cooling fluid flow path (R), the electronic components (15, 16, 21, 22, 66, T) are disposed at both sides of each of the number of plurality plates (11, 12), the electronic components (15, 16, 21, 22, 66, T) facing the cooling plates (11, 12), and the electronic components (15, 16, 21, 22, 66, T) are cooled via the facing cooling plates (11, 12).

## Description

### TECHNICAL FIELD

The present disclosure relates to an electronic component cooling structure and a vehicle driving device.

### BACKGROUND DISCUSSION

In recent years, an automobile (hybrid electric vehicle (HEV), plug-in hybrid electric vehicle (PHEV), battery electric vehicle (BEV), fuel cell electric vehicle (FCEV), and the like) including a motor as a traveling drive source has been widely used. Hereinafter, these automobiles are collectively referred to as electric vehicles. In an electric vehicle, there are many devices that require cooling, such as a motor (including an internal combustion engine such as an engine), a battery, an air conditioner, and an ECU. Therefore, a cooling circuit that circulates a cooling liquid, a refrigerant, and oil is configured to cool these devices.

JP 2020 061892 A discloses a power supply device including a housing partitioned into a first space and a second space by a partition member, and a transformer that transforms a voltage of input power to output the transformed voltage. In this power supply device, a first circuit portion of the transformer to which a first voltage of input power is applied is stored in a first space, and a second circuit portion of the transformer to which a second voltage transformed from the first voltage is applied is stored in a second space. The first circuit portion and the second circuit portion are electrically connected via a hole provided in the partition member in the housing. The partition member has a heat dissipation fin, and the first circuit portion and the second circuit portion are in contact with the partition member.

JP 2018-512742 W discloses a power electronics module including a plurality of semiconductor chips, and a first liquid cooler and a second liquid cooler that cool the plurality of semiconductor chips. In the power electronics module, the first liquid cooler and the second liquid cooler are disposed in a stacked manner, and the plurality of semiconductor chips is disposed between the first liquid cooler and the second liquid cooler.

In the power supply device disclosed in JP 2020 061892, the first circuit portion and the second circuit portion are disposed on both sides of a partition member having a heat dissipation fin. Therefore, when the number of components constituting the first circuit portion or the second circuit portion increases, it is necessary to increase the area of the partition member facing the first circuit portion and the second circuit portion. Accordingly, since the size of the power supply device also increases, there is room for improvement.

In the power electronics module disclosed in JP 2018-512742 W, the first liquid cooler and the second liquid cooler face the plurality of semiconductor chips. However, no component such as a semiconductor chip is disposed at a face not facing the plurality of semiconductor chips among the two faces of each of the first liquid cooler and the second liquid cooler. Therefore, the cooling functions of the first liquid cooler and the second liquid cooler cannot be sufficiently utilized, and there is room for improvement.

A need thus exists for an electronic component cooling structure and a vehicle driving device that can efficiently cool a plurality of electronic components, and can downsize a device on which these electronic components are mounted.

### SUMMARY

An embodiment of an electronic component cooling structure according to the present disclosure is an electronic component cooling structure in which a plurality of cooling plates each having a cooling fluid flow path therein is disposed, cooling fluid for cooling an electronic components flowing through the cooling fluid flow path, wherein the electronic components are disposed at both sides of each of the plurality of cooling plates, the electronic components facing the cooling plates, and wherein the electronic components are cooled via the facing cooling plates.

According to the present embodiment, since the plurality of cooling plates is disposed, the degree of freedom of arrangement of the plurality of electronic components can be enhanced by disposing the plurality of cooling plates as long as the area of the cooling plates is the same, compared with the configuration in which only one cooling plate is disposed. A plurality of electronic components is disposed at both sides of each of the plurality of cooling plates, the electronic components facing the cooling plates, and the electronic components are cooled via the facing cooling plates. Therefore, the cooling area of the cooling plate can be doubled, compared with the case where the electronic component is cooled using only one face of the cooling plate. Therefore, the plurality of electronic components can be cooled in a space-saving manner.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a longitudinal sectional view of a vehicle driving device accommodating a conversion module;
Fig. 2 is a perspective view of a power conversion device including an inverter;
Fig. 3 is an exploded perspective view of the power conversion device;
Fig. 4 is a plan view of a support member;
Fig. 5 is a circuit diagram of a cooling circuit illustrating a cooling fluid flow path and a refrigerant flow path;
Fig. 6 is a circuit diagram of a power conversion circuit of the power conversion device;
Fig. 7 is a cross-sectional view illustrating an outline of a power conversion device;
Fig. 8 is a cross-sectional view taken along line VII-VII of Fig. 1;
Fig. 9 is a cross-sectional view taken along a line VIII-VIII in Fig. 1; and
Fig. 10 is an exploded perspective view of a vehicle driving device and a housing according to another embodiment (e).

### DETAILED DESCRIPTION

Hereinafter, embodiments of an electronic component cooling structure and a vehicle driving device according to the present disclosure will be described in detail with reference to the drawings. Note that the embodiments described below are examples for describing the present disclosure, and the present disclosure is not limited only to these embodiments. Therefore, the present disclosure can be implemented in various forms without departing from the gist thereof.

### [Basic configuration]

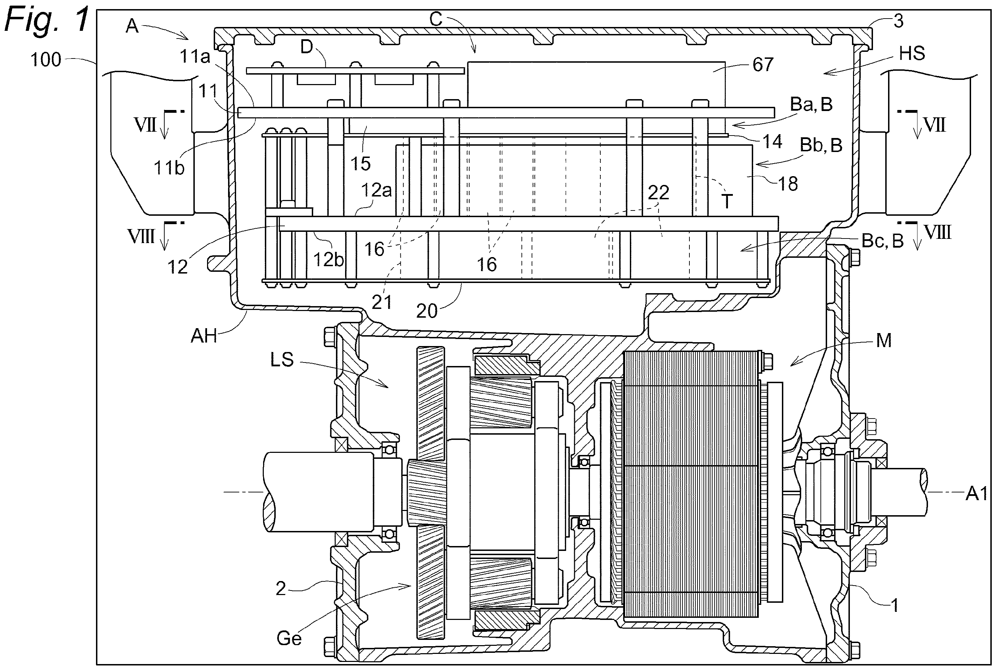

Fig. 1 illustrates a vehicle driving device A that transmits a driving force of a traveling motor M (an example of a motor) to wheels (not illustrated). In the vehicle driving device A, the traveling motor M, a gear mechanism Ge that decelerates a driving force of the traveling motor M to transmit the driving force to driving wheels, a power conversion device B, and an inverter C are accommodated in a housing AH. Hereinafter, a vehicle including the traveling motor M as a traveling drive source is also referred to as an electric vehicle. Examples of the electric vehicle include a hybrid electric vehicle (HEV), a plug-in hybrid electric vehicle (PHEV), a battery electric vehicle (BEV), and a fuel cell electric vehicle (FCEV).

Since the vehicle driving device A is provided in an electric vehicle 100 in the vertical relationship illustrated in Fig. 1, the vertical relationship according to the vertical direction illustrated in Fig. 1 will be described in the present embodiment. Fig. 1 illustrates a longitudinal cross section of the vehicle driving device A when viewed in the front-rear direction, and the left-right direction in Fig. 1 is the width direction of the vehicle body.

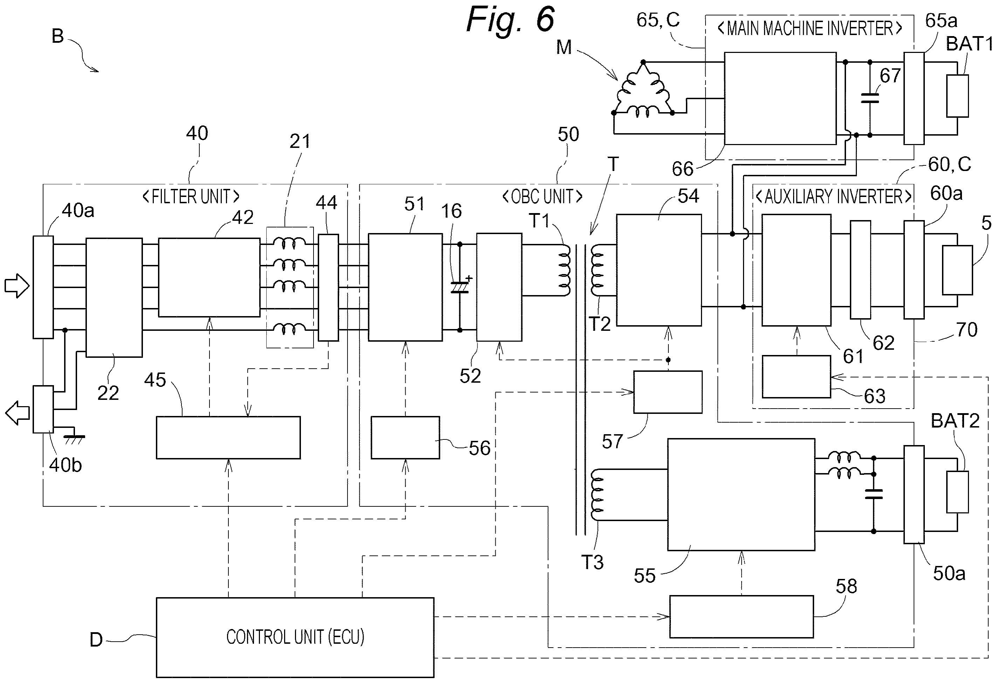

As illustrated in Fig. 6, the power conversion device B converts AC power from an AC power supply (basically, a commercial power supply) supplied from the outside of the electric vehicle 100 (see Fig. 1) into high-voltage DC power. The converted high-voltage DC power is charged in a main battery BAT1 (an example of a battery) disposed outside vehicle driving device A. In addition, the power conversion device B converts DC power from the main battery BAT1, generates AC power as in the commercial power supply, and supplies the AC power to the outside of the electric vehicle 100.

As illustrated in Fig. 6, the inverter C converts DC power from the main battery BAT1 into three-phase AC power, controls the frequency, and supplies the three-phase AC power to the traveling motor M. Accordingly, the drive wheels of the electric vehicle 100 are driven to cause the electric vehicle 100 to travel.

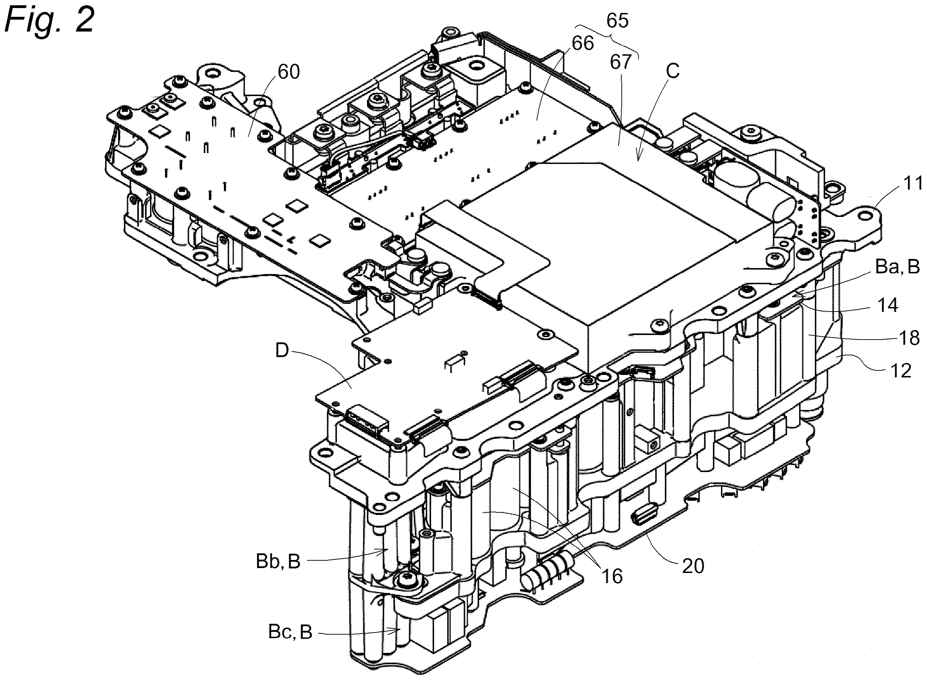

As illustrated in Figs. 1 and 2, the power conversion device B includes a plurality of layers in which a plurality of conversion modules (first conversion module Ba, second conversion module Bb, and third conversion module Bc) are disposed in an overlapping manner in the vertical direction. The inverter C is provided above the power conversion device B.

### [Vehicle driving device]

As illustrated in Fig. 1, the vehicle driving device A accommodates the traveling motor M and the gear mechanism Ge in a lower space LS of the housing AH. In the vehicle driving device A, an outer portion of the traveling motor M in the lower space LS is closed by a motor cover 1, and an outer portion of the gear mechanism Ge in the lower space LS is closed by a gear cover 2. The rotation axis A1 of the traveling motor M is coaxial with the rotation axis of the gear mechanism Ge.

The vehicle driving device A accommodates the power conversion device B and the inverter C in an upper space HS of the housing AH. The upper space HS is closed by an upper cover 3. The lower space LS and the upper space HS are independent spaces that do not communicate with each other.

In the present embodiment, as described above, the power conversion device B and the inverter C are accommodated in an integrated manner in the housing AH of the vehicle driving device A, but the power conversion device B may be separated from the inverter C. Further, the vehicle driving device A has a configuration in which each of the power conversion device B and the inverter C is accommodated inside, but at least one of the power conversion device B and the inverter C may be disposed on an outer wall face or outside of the housing AH of the vehicle driving device A.

### [Layer structure of power conversion device]

As illustrated in Figs. 1 to 3, in the power conversion device B, the first conversion module Ba, the second conversion module Bb, and the third conversion module Bc are disposed in this order from the top to the bottom. In the power conversion device B, a first cooling plate 11 (an example of a cooling plate) is disposed in an upper stage, a second cooling plate 12 (an example of a cooling plate) is disposed below the first cooling plate 11 in the vertical direction, and these cooling plates are connected to each other via a spacer or the like. Accordingly, the first cooling plate 11 and the second cooling plate 12 are disposed in a stacked manner at preset intervals in this order from the top along the vertical direction. Each of the first cooling plate 11 and the second cooling plate 12 has a plate shape.

Each of the first cooling plate 11 and the second cooling plate 12 has a flow path R (an example of a cooling fluid flow path) through which a cooling liquid (an example of a cooling fluid) flows, and a cooling liquid such as a long life cooling liquid (LLC) containing ethylene glycol, propylene glycol, or the like, insulating oil, or the like flows through the flow path R. This makes it possible to cool various electronic components constituting the first conversion module Ba, the second conversion module Bb, and the third conversion module Bc disposed to face the upper and lower plate faces of each of the first cooling plate 11 and the second cooling plate 12. Such a configuration is the electronic component cooling structure according to the present embodiment.

As a specific arrangement, in the power conversion device B, the first conversion module Ba and the second conversion module Bb are disposed between a first lower face 11b (an example of a lower face) of the first cooling plate 11 and a second upper face 12a (an example of the upper face) of the second cooling plate 12. The third conversion module Bc is disposed on a second lower face 12b (an example of the lower face) of the second cooling plate 12. The inverter C is disposed on a first upper face 11a (an example of the upper face) of the first cooling plate 11.

The first conversion module Ba is disposed to face the first lower face 11b of the first cooling plate 11, and is cooled by the cooling liquid flowing through the first cooling plate 11. The second conversion module Bb is disposed to face the second upper face 12a of the second cooling plate 12, and is cooled by the cooling liquid flowing through the second cooling plate 12. The third conversion module Bc is disposed to face the second lower face 12b of the second cooling plate 12, and is cooled by the cooling liquid flowing through the second cooling plate 12.

The first conversion module Ba includes a plurality of switching elements 15 (an example of the electronic component and the inter-plate electronic component) mounted at the upper face of a plate-shaped upper substrate 14. The upper substrate 14 is supported by the first cooling plate 11 in a state of being separated downward from the first lower face 11b of the first cooling plate 11. The plurality of switching elements 15 constitutes part of an on board charger (OBC) unit 50 (example of the on-board charger, see Fig. 6) to be described later.

In Fig. 1, the plurality of switching elements 15 is illustrated as one block. The plurality of switching elements 15 is disposed in contact with or in proximity to the first lower face 11b of the first cooling plate 11. Accordingly, the plurality of switching elements 15 is cooled by the first cooling plate 11.

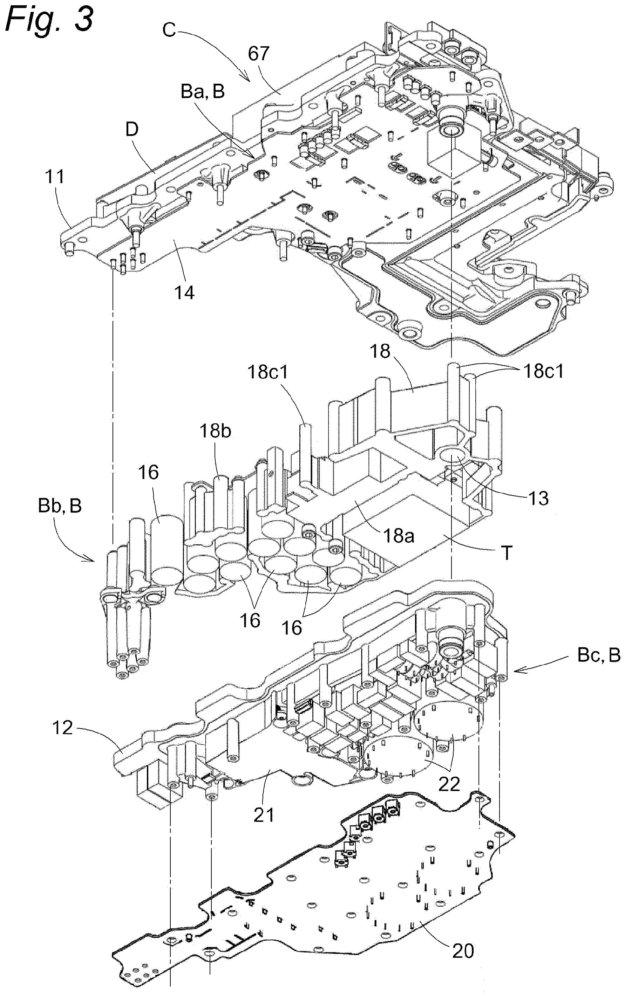

As illustrated in Fig. 3, the second conversion module Bb includes a transformer T (an example of the electronic component and the inter-plate electronic component) mounted at the lower face of the upper substrate 14, a plurality of bulk capacitors 16 (an example of the electronic component and the inter-plate electronic component), and a frame member 18. The frame member 18 functions as a spacer by protruding downward from the lower face of the upper substrate 14 in a state of surrounding at least part of the outer periphery of the transformer T or at least part of the plurality of bulk capacitors 16. The plurality of bulk capacitors 16 and the transformer T are electronic components having a relatively larger weight than other electronic components disposed in the same layer. The lower faces of the plurality of bulk capacitors 16 and the lower face of the transformer T are disposed in contact with or in proximity to the second upper face 12a of the second cooling plate 12. Accordingly, the plurality of bulk capacitors 16 and the transformer T are cooled by the second cooling plate 12. Thus, the inter-plate electronic components disposed between the first cooling plate 11 and the second cooling plate 12 are cooled any of the first cooling plate 11 or the second cooling plate 12.

As described later, the plurality of bulk capacitors 16 has a relatively lower heat-resistant temperature (heat resistance) than another electronic component. By disposing such an electronic component having a low heat-resistant temperature between the first cooling plate 11 and the second cooling plate 12, it is possible to block the influence of heat generated by an electronic component having a large amount of heat generation such as the inverter C described later. As described above, the inverter C is disposed on the first upper face 11a of the first cooling plate 11, and the first cooling plate 11 is disposed between the plurality of bulk capacitors 16 and the inverter C.

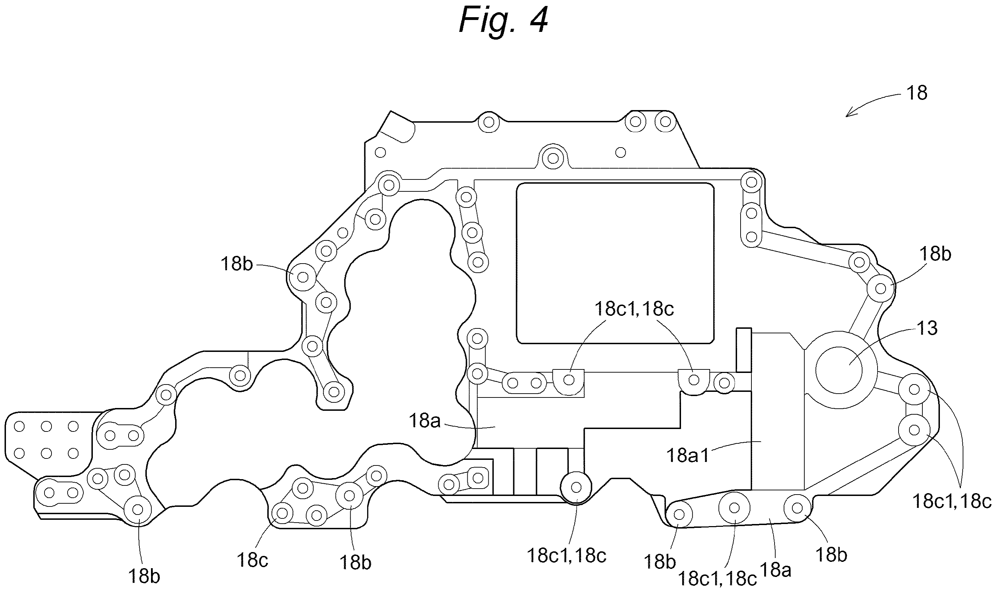

As illustrated in Figs. 3 and 4, the frame member 18 includes a plurality of wall portions 18a overlapping at least part of the transformer T or the bulk capacitor 16 in side view, a plurality of protrusions 18b protruding from the upper face of the second cooling plate 12 along the stacking direction and facing the first lower face 11b of the first cooling plate 11, and a plurality of protrusions 18c protruding from the upper face of the second cooling plate along the stacking direction and facing the lower face of the upper substrate 14. The wall portion 18a is disposed so as to surround the end portion of the second cooling plate 12 and part of the side faces of the transformer T and the bulk capacitor 16. The protrusions 18b and 18c may be connected to the wall portion 18a. The upper faces of the protrusions 18b and 18c may be located above the upper face of the wall portion 18a, or may be located on the same plane as the upper face of the wall portion 18a. A connection hole for connecting the frame member 18 and the first cooling plate 11 or the upper substrate 14 is formed at the upper faces of the protrusions 18b and 18c. A connection member (not illustrated) such as a bolt is inserted into the connection hole in a state where the upper faces of the protrusions 18b and 18c and the first lower face 11b of the first cooling plate 11 or the lower face of the upper substrate 14 are in contact with each other, whereby the upper substrate 14, the first cooling plate 11, and the frame member 18 are connected. The protrusion 18c is in contact with the first cooling plate 11 via the connection member.

As illustrated in Fig. 4, among the plurality of protrusions 18c, the cross-sectional area of the protrusion 18c1 in the direction orthogonal to the stacking direction is formed to be larger than the cross-sectional area of the protrusion 18c at another place. Since the areas of the holes formed on the upper faces of the protrusion 18c and the protrusion 18c1 are equal to each other, the protrusion 18c1 is thicker than the protrusion 18c. Accordingly, the contact area between the upper face of the protrusion 18c1 and the first lower face 11b of the first cooling plate 11 can be increased, so that heat exchange is easily performed between the protrusion 18c1 and the first cooling plate 11, and the frame member 18 can be cooled. Therefore, by disposing the protrusion 18c1 in the vicinity of the switching element 15 having a large amount of current and a large amount of heat generation and the board wiring that generates heat by an energization current, the switching element 15 and the board wiring that generates heat by an energization current can be cooled via the protrusion 18c1.

As illustrated in Figs. 1 and 3, the third conversion module Bc includes a plurality of coil modules 21 (an example of the electronic component) and a plurality of AC filters 22 (an example of the electronic component and the filter substrate) mounted at the upper face of a lower substrate 20 disposed to be separated downward from the second lower face 12b of the second cooling plate 12. The plurality of coil modules 21 and the plurality of AC filters 22 are electronic components having a relatively larger weight than other electronic components disposed in the same layer. The upper faces of the plurality of coil modules 21 and the upper faces of the plurality of AC filters 22 are disposed in contact with or in proximity to the second lower face 12b of the second cooling plate 12. Accordingly, the plurality of coil modules 21 and the plurality of AC filters 22 are cooled by the second cooling plate 12.

### [Cooling circuit]

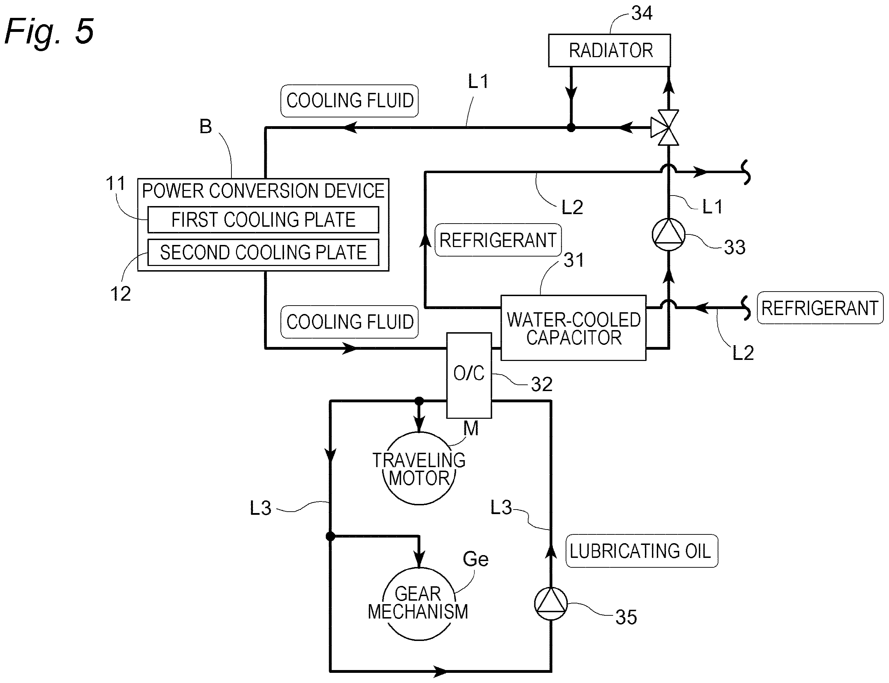

As illustrated in Fig. 5, the vehicle driving device A includes a cooling circuit including a cooling liquid flow path L1 for circulating a cooling liquid as a cooling fluid, a refrigerant flow path L2 for circulating a refrigerant, and a lubricating oil flow path L3 for circulating a lubricating oil.

The cooling liquid flow path L1 circulates the cooling liquid through a radiator 34, the first cooling plate 11 and the second cooling plate 12 of the power conversion device B, an oil cooler 32, and a water-cooled capacitor 31 in this order by driving the cooling liquid pump 33. The above-described flow path R is part of the cooling liquid flow path L1.

Refrigerant flow path L2 is configured to supply an externally cooled refrigerant to the water-cooled capacitor 31. In the refrigerant flow path L2, hydrofluorocarbon (HFC), hydrofluoroolefin (HFO), or the like is used as the refrigerant.

The lubricating oil flow path L3 supplies low-temperature lubricating oil to the inside of the traveling motor M and the gear mechanism Ge by driving of a hydraulic pump 35.

In this cooling circuit, the cooling liquid cooled by the radiator 34 flows to the flow path R of the first cooling plate 11 and the flow path R of the second cooling plate 12 of the power conversion device B. Accordingly, the cooling liquid deprives heat generated in the first conversion module Ba, the second conversion module Bb, and the third conversion module Bc, and cools the first conversion module Ba, the second conversion module Bb, and the third conversion module Bc. As a result, the temperature of the cooling liquid rises.

The oil cooler 32 is disposed downstream of the power conversion device B in the cooling liquid flow path L1, and performs heat exchange between the cooling liquid circulating in the cooling liquid flow path L1 and the oil. Accordingly, the temperature of the cooling liquid further increases, and the temperature of the oil decreases. In this manner, the oil whose temperature has decreased is circulated through the lubricating oil flow path L3. Accordingly, the temperature rise of the traveling motor M and the gear mechanism Ge in the lower space LS of the housing AH is suppressed, and the traveling motor M and the gear mechanism Ge are lubricated. The cooling liquid whose temperature has increased in the oil cooler 32 takes heat from the refrigerant in the water-cooled capacitor 31, and then the temperature of the cooling liquid decreases due to heat radiation in the radiator 34, and the cooling liquid is supplied to the power conversion device B again.

### [Configuration of power conversion circuit]

Fig. 6 illustrates a circuit diagram of a power conversion circuit of the power conversion device B. The power conversion circuit includes a filter unit 40, an OBC unit 50, an auxiliary inverter unit 60 and a main machine inverter unit 65 constituting the inverter C, and a control unit D.

### [Power conversion circuit: Filter unit]

The filter unit 40 includes an input connector 40a, an output connector 40b, an AC filter 22, a relay module 42, a coil module 21, a current detection module 44, and an input/output control unit 45.

As illustrated in Figs. 1 and 3, the plurality of coil modules 21 and the plurality of AC filters 22 of the filter unit 40 are provided in the third conversion module Bc.

In addition, the input/output control unit 45 outputs a control signal to the relay module 42 and acquires a detection signal of the current detection module 44.

### [Power conversion circuit: OBC unit]

As illustrated in Fig. 6, the OBC unit 50 includes the transformer T, a low-voltage connector 50a, a conversion circuit 51, a primary coil control circuit 52, a bulk capacitor 16, a secondary coil control circuit 54, a tertiary coil control circuit 55, a conversion circuit control unit 56, a transformer control unit 57, and a low-voltage control unit 58. The primary coil control circuit 52 controls a primary coil T1 of the transformer T. The bulk capacitor 16 is disposed in a power system that transmits power from the conversion circuit 51 to the primary coil control circuit 52. The secondary coil control circuit 54 controls a secondary coil T2 of the transformer T. The tertiary coil control circuit 55 obtains power from a tertiary coil T3 of the transformer T. The low-voltage connector 50a supplies power from the tertiary coil control circuit 55 to a low-voltage system battery BAT2 (an example of a battery).

In the OBC unit 50, the plurality of switching elements 15 constituting part of the conversion circuit 51, the primary coil control circuit 52, the secondary coil control circuit 54, and the like is mounted as the first conversion module Ba at the upper face of the upper substrate 14 and cooled by the first cooling plate 11 (see Fig. 1).

As illustrated in Figs. 1 and 3, the transformer T of the OBC unit 50 and the plurality of bulk capacitors 16 are mounted at the lower face of the upper substrate 14 to constitute the second conversion module Bb. The transformer T, the plurality of bulk capacitors 16, and elements related thereto may be provided on a substrate different from the upper substrate 14.

As illustrated in Fig. 6, the conversion circuit control unit 56 controls the plurality of switching elements 15 of the conversion circuit 51. In addition, the transformer control unit 57 controls the plurality of switching elements 15 of the primary coil control circuit 52 and the plurality of switching elements 15 of the secondary coil control circuit 54. The low-voltage control unit 58 controls the plurality of switching elements 15 of the tertiary coil control circuit 55.

### [Power conversion circuit: auxiliary inverter unit]

As illustrated in Fig. 6, the auxiliary inverter unit 60 of the inverter C functions as a DC-DC converter 70 (hereinafter, also referred to as a converter 70), and includes a first high-voltage connector 60a, an auxiliary drive circuit 61, a DC filter 62, and an auxiliary control unit 63.

The auxiliary drive circuit 61 includes a plurality of switching elements. The auxiliary control unit 63 controls the auxiliary drive circuit 61 to supply high voltage power to an air conditioner 5 and the like as an auxiliary machine via the first high-voltage connector 60a. That is, the converter 70 includes a plurality of switching elements.

As illustrated in Fig. 2, the auxiliary inverter unit 60 of the inverter C is disposed above the first cooling plate 11 in a region protruding outward from the first cooling plate 11 when viewed in the vertical direction.

### [Power conversion circuit: main machine inverter unit]

As illustrated in Fig. 6, the main machine inverter unit 65 of the inverter C includes a second high-voltage connector 65a, a motor drive circuit 66 (an example of the electronic component and the drive circuit), and a smoothing capacitor 67. The motor drive circuit 66 includes a plurality of switching elements and supplies power to the traveling motor M. The motor drive circuit 66 is disposed at a position adjacent to the smoothing capacitor 67.

As illustrated in Fig. 2, the main machine inverter unit 65 including the motor drive circuit 66 and the smoothing capacitor 67 is disposed in contact with or in proximity to the first upper face 11a of the first cooling plate 11. Accordingly, the main machine inverter unit 65 is cooled by the first cooling plate 11.

When high voltage power flowing between the OBC unit 50 and the auxiliary inverter unit 60 is supplied, the main machine inverter unit 65 functions to supply the high voltage power from the second high-voltage connector 65a to the main battery BAT1 to perform charging. Therefore, in a broad sense, the on-board charger can include the OBC unit 50 and the main machine inverter unit 65.

In addition, the main machine inverter unit 65 converts the power from the main battery BAT1 into three-phase AC power by the motor drive circuit 66, controls the frequency, and supplies the three-phase AC power to the traveling motor M, thereby obtaining the driving force that enables the traveling of the electric vehicle 100 from the traveling motor M.

### [Power conversion circuit: Control unit]

As illustrated in Fig. 6, the control unit D outputs control signals to the input/output control unit 45, the conversion circuit control unit 56, the transformer control unit 57, the low-voltage control unit 58, and the auxiliary control unit 63.

As illustrated in Fig. 2, the control unit D is disposed at a position adjacent to the smoothing capacitor 67 and overlapping over the first cooling plate 11. Accordingly, the control unit D is cooled by the first cooling plate 11.

### [Power conversion circuit: Flow of current]

Under the control of the relay module 42, the power conversion circuit converts AC power from an AC power supply (basically, a commercial power supply) supplied from the outside of the electric vehicle 100 to the input connector 40a into DC power by the conversion circuit 51, and supplies AC of a set frequency generated by the primary coil control circuit 52 to the primary coil T1 of the transformer T.

The high-voltage power output to the secondary coil T2 of the transformer T is taken out as high-voltage DC power by the secondary coil control circuit 54, and charged into the main battery BAT1 from the second high-voltage connector 65a.

The high-voltage DC power charged in the main battery BAT1 is converted into three-phase AC power by the motor drive circuit 66, and the three-phase AC power is supplied to the traveling motor M by controlling the frequency. Accordingly, the traveling motor M is driven at the target rotation speed, and the traveling of the electric vehicle 100 is realized. The high-voltage DC power from main battery BAT1 is DC-DC converted by auxiliary drive circuit 61, and supplied from first high-voltage connector 60a to the air conditioner 5 and the like.

On the other hand, the low-voltage power output to the tertiary coil of the transformer T is charged as direct-current power by the tertiary coil control circuit 55 from the low-voltage connector 50a to the system battery BAT2. The electric power charged in the system battery BAT2 in this manner is supplied to the control device and the control equipment of the vehicle body of the electric vehicle 100.

Further, under the control of the relay module 42, the power conversion circuit sequentially supplies power from the main battery BAT1 to the secondary coil control circuit 54, the transformer T, the primary coil control circuit 52, and the like, thereby generating an AC power supply similar to a commercial power supply to output the AC power from the output connector 40b.

### [Cooling mechanism]

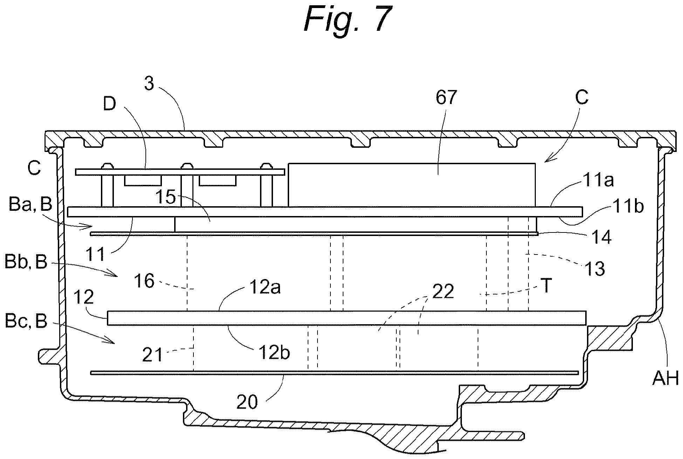

The power conversion device B is cooled by the cooling liquid flowing through the first cooling plate 11 and the second cooling plate 12. As illustrated in Fig. 7, the first cooling plate 11 and the second cooling plate 12 are configured so that the flow path R is continuous between the first cooling plate 11 and the second cooling plate 12 by a communication passage 13 extending in the vertical direction. The communication passage 13 is integrally formed with the frame member 18.

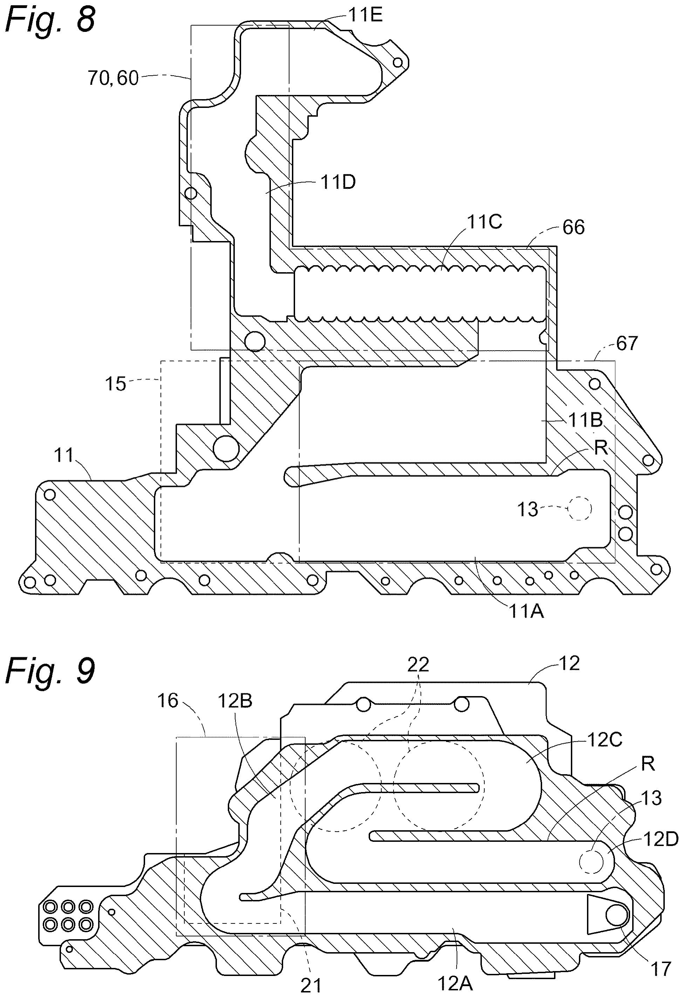

The cooling liquid cooled by the radiator 34 or the like and reaching the power conversion device B flows into the flow path R of the second cooling plate 12 from a flow inlet 17 of the second cooling plate 12 illustrated in Fig. 9. The second cooling plate 12 continuously includes a first portion 12A, a second portion 12B, a third portion 12C, and a fourth portion 12D. The flow path R is formed so that the cooling liquid flows through the first portion 12A, the second portion 12B, the third portion 12C, and the fourth portion 12D in this order. The first portion 12A is extended in the longitudinal direction of the lower substrate 20 (see Fig. 7, hereinafter, the same applies). The second portion 12B is folded back from an end portion of the first portion 12A, bent and extended. The third portion 12C is folded back in the longitudinal direction of the lower substrate 20 from the end portion of the second portion 12B and extended. The fourth portion 12D is folded back in the longitudinal direction of the lower substrate 20 from the end portion of the third portion 12C and extended. The end portion of the fourth portion 12D is connected to the end portion of the communication passage 13.

The cooling liquid having flowed through the flow path R formed in the communication passage 13 reaches the first cooling plate 11. As illustrated in Fig. 8, the first cooling plate 11 continuously includes a first portion 11A, a second portion 11B, a third portion 11C, a fourth portion 11D, and a fifth portion 11E. The flow path R is formed so that the cooling liquid flows through the first portion 11A, the second portion 11B, the third portion 11C, the fourth portion 11D, and the fifth portion 11E in this order. The first portion 11A is extended in the longitudinal direction of the lower substrate 20. The second portion 11B is folded back from the end portion of the first portion 11A and extended in the longitudinal direction of the lower substrate 20. The third portion 11C is folded back in the longitudinal direction of the lower substrate 20 from the end portion of the second portion 11B and extended. The fourth portion 11D is folded back so as to be perpendicular to the longitudinal direction of lower substrate 20 from an end of third portion 11C and extended. The fifth portion 11E is folded back in the longitudinal direction of the lower substrate 20 from the end portion of the fourth portion 11D and extended. A flow outlet (not illustrated) is formed at a downstream end of the fifth portion 11E, and the cooling liquid flows out of the power conversion device B from the flow outlet.

Table 1 shows a comparison between the amount of power generation and the heat-resistant temperature (heat resistance) of each electronic components.

**[Table 1]**

| | Conversion module | | Main machine inverter unit | | Converter | Motor |
|---|---|---|---|---|---|---|
| Cooling target | Bulk capacitor | Switching element | Smoothing capacitor | Motor drive circuit | Switching element | |
| Amount of heat generation | Small | Small | Large | Large | Small | Large |
| Heat-resistant temperature | Low | High | Low | High | High | High |
| Pattern | A | B | C | D | B | D |

That is, the conversion modules Ba, Bb, and Bc (conversion modules) has, for example, a current value of 50 A or less, and the bulk capacitor 16 (pattern A) has a relatively smaller amount of heat generation and a relatively lower heat-resistant temperature than other electronic components. The switching element 15 (pattern B) has a relatively small amount of heat generation and a relatively high heat-resistant temperature.

The main machine inverter unit 65 has, for example, a current of 700 A or less, and the smoothing capacitor 67 (pattern C) has a relatively larger amount of heat generation and a relatively lower heat-resistant temperature than other electronic components. The motor drive circuit 66 (pattern D) has a relatively large amount of heat generation and has a relatively high heat-resistant temperature.

The converter 70 has, for example, a current of 20 A or less, and the switching element (pattern B) of the converter 70 has a relatively smaller amount of heat generation and a relatively higher heat-resistant temperature than other electronic components. The traveling motor M (pattern D) has, for example, a current of 700 A or less, and has a relatively larger amount of heat generation and a relatively higher heat-resistant temperature than other electronic components.

In the present embodiment, the bulk capacitor 16 is disposed at a position corresponding to the first portion 12A and the second portion 12B of the second cooling plate 12, and the AC filter 22 is disposed at a position corresponding to the third portion 12C of the second cooling plate 12 (see Fig. 9). The switching element 15 of the first conversion module Ba is disposed at a position corresponding to the boundary between the first portion 11A and the second portion 11B of the first cooling plate 11 (see Fig. 8).

In the main machine inverter unit 65, the smoothing capacitor 67 is disposed at a position corresponding to the first portion 11A and the second portion 11B of the first cooling plate 11, and the switching element of the motor drive circuit 66 is disposed at a position corresponding to the third portion 11C of the first cooling plate 11 (see Fig. 8).

The converter 70 is disposed at a position corresponding to the fourth portion 11D of first cooling plate 11 (see Fig. 8).

As described above, the cooling plates 11 and 12 has the flow path R so that the cooling liquid flows through the bulk capacitor 16 of the second conversion module Bb, the AC filter 22, the switching element 15 of the first conversion module Ba, the smoothing capacitor 67 of the main machine inverter unit 65, the motor drive circuit 66 (switching element) of the inverter C, and the switching element of the converter 70 in this order.

In this way, since the power conversion device B is cooled by the cooling liquid flowing through the first cooling plate 11 and the second cooling plate 12, an excessive temperature rise is not caused. Similarly, since the inverter C is cooled by the cooling liquid flowing through the first cooling plate 11, an excessive temperature rise is not caused.

In addition, since the wall portion 18a1 is connected to the communication passage 18, the frame member 13 is cooled by performing heat exchange with the communication passage 13 via the wall portion 18a1. Therefore, the bulk capacitor 16 disposed in the vicinity of the frame member 18, the switching element 15 of the first conversion module Ba, and the board wiring that generates heat by an energization current are also cooled by the cooling liquid flowing through the communication passage 13. Therefore, since the electronic component disposed between the first cooling plate 11 and the second cooling plate 12 is cooled by the cooling liquid flowing through the first cooling plate 11, the communication passage 13, and the second cooling plate 12, it is possible to more efficiently cool the power conversion device B with the upper face, the lower face, and the side face thereof.

The wall portion 18a1 connected to the communication passage 13 is preferably formed to be thicker than the other wall portions 18a. Accordingly, since the wall portion 18a1 is easily cooled by the cooling liquid flowing through the communication passage 13, the power conversion device B can be more efficiently cooled via the frame member 18. In addition, not only the wall portion 18a1 but also another wall portion 18a in contact with the first cooling plate 11 may be thickened. Accordingly, the cooling efficiency is enhanced, and the vibration resistance against external vibration or the like is enhanced, so that the strength of the power conversion device B can be improved.

### [Other embodiments]

The present disclosure may be configured as follows in addition to the above-described embodiment (those having the same functions as those in the embodiment are designated by the same number and reference numeral as those in the embodiment).
(a) In the above embodiment, it is described that the power conversion device B includes the cooling plates 11 and 12 through which the cooling liquid flows as the cooling fluid along each of the plurality of conversion modules Ba, Bb, and Bc, but the present invention is not limited thereto. The power conversion device B may have a configuration in which a liquid refrigerant (an example of a cooling fluid) flows inside the cooling plates 11 and 12. In addition, the power conversion device B may have a configuration in which a gaseous refrigerant (an example of a cooling fluid) flows inside the cooling plates 11 and 12.
(b) In the above embodiment, the configuration in which the cooling plates 11 and 12 are disposed vertically in a stacked manner is described, but one cooling plate may be provided, or three or more cooling plates may be disposed in a stacked manner.
(c) In the above embodiment, the cooling plates 11 and 12 have the configuration in which the flow path R is formed so that the cooling liquid flows through the bulk capacitor 16, the AC filter 22, the switching element 15, the smoothing capacitor 67 of the main machine inverter unit 65, the motor drive circuit 66, and the converter 70. Alternatively, the cooling plates 11 and 12 may have the following configurations. The cooling plates 11 and 12 may have a flow path R so that a cooling liquid flows through at least the bulk capacitor 16, the switching element 15, and the motor drive circuit 66 of the main machine inverter unit 65. Alternatively, the cooling plates 11 and 12 may have a flow path R so that the cooling liquid flows through at least the bulk capacitor 16, the switching element 15, the motor drive circuit 66 of the main machine inverter unit 65, and the converter 70.
(d) In the above embodiment, the electronic components are disposed as follows. That is, the main machine inverter unit 65 including the motor drive circuit 66 and the smoothing capacitor 67 is disposed to face the first upper face 11a of the first cooling plate 11, and the plurality of switching elements 15 of the OBC unit 50 is disposed to face the first lower face 11b. The plurality of bulk capacitors 16 and the transformer T are disposed to face the second upper face 12a of the second cooling plate 12, and the plurality of coil modules 21 and the plurality of AC filters 22 are disposed to face the second lower face 12b. However, the arrangement of each electronic component along the vertical direction may be opposite to the above arrangement. That is, the plurality of coil modules 21 and the plurality of AC filters 22 may be disposed to face the first upper face 11a of the first cooling plate 11, and the plurality of bulk capacitors 16 and the transformer T may be disposed to face the first lower face 11b. The plurality of switching elements 15 of the OBC unit 50 may be disposed to face the second upper face 12a of the second cooling plate 12, and the main machine inverter unit 65 including the motor drive circuit 66 and the smoothing capacitor 67 may be disposed to face the second lower face 12b.

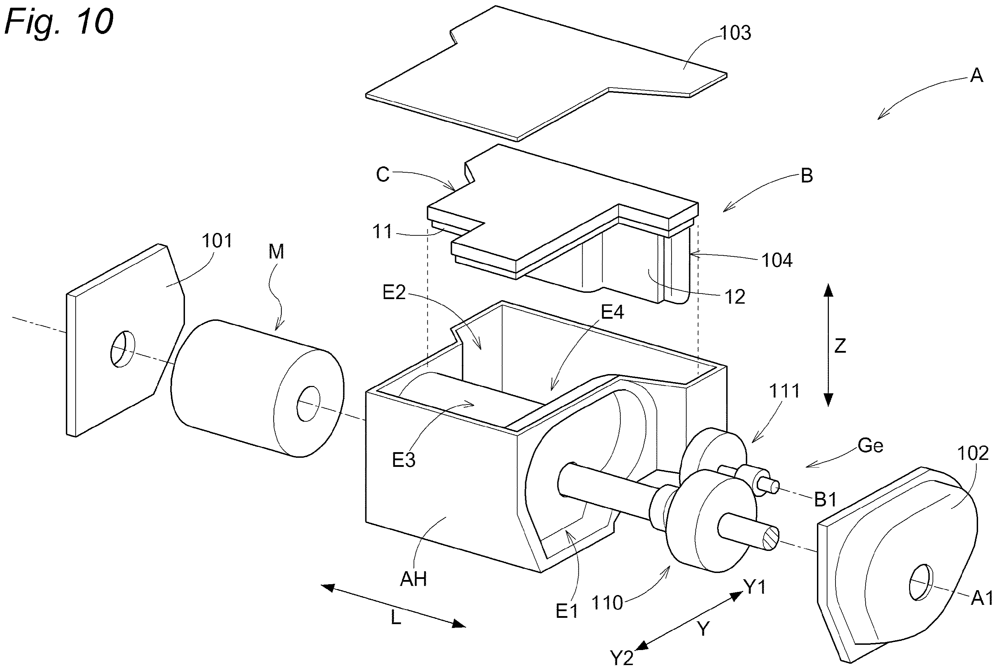

(e) Fig. 10 illustrates the vehicle driving device A that transmits the driving force of the traveling motor M to the wheels (not illustrated) with respect to the housing AH. The vehicle driving device A includes the traveling motor M, the gear mechanism Ge that decelerates a driving force of the traveling motor M to transmit the decelerated driving force to driving wheels, the power conversion device B, and the inverter C accommodated in the housing AH.

The housing AH includes a first accommodation chamber E1 that accommodates the traveling motor M, and a second accommodation chamber E2 that accommodates the power conversion device B that controls power supplied to the traveling motor M and the inverter C. A direction perpendicular to the vertical direction Z and along the rotation axis A1 of a rotor (not illustrated) of the traveling motor M is defined as an axial direction L, a direction orthogonal to the vertical direction Z and the axial direction L is defined as an axial orthogonal direction Y, and one of the axial orthogonal direction Y is defined as a first axial orthogonal direction Y1.

In the housing AH, an outer portion of the traveling motor M in the first accommodation chamber E1 is closed by a first cover 101, and an outer portion of the gear mechanism Ge in the first accommodation chamber E1 is closed by a second cover 102. An upper opening of the housing AH is closed by an upper cover 103. Accordingly, the housing AH has a sealing structure.

The gear mechanism Ge includes a differential gear mechanism 110 disposed on the same axis as the rotation axis A1 of the traveling motor M, and a counter gear mechanism 111 disposed on an offset axis B1 offset from the rotation axis A1.

The second accommodation chamber E2 includes an upper region E3 that is a region above the traveling motor M in the vertical direction Z and overlapping the traveling motor M when viewed in the vertical direction, and a side region E4 that is adjacent to the upper region E3, is in the first axial orthogonal direction Y1 with respect to the traveling motor M, and does not overlap the traveling motor M when viewed in the vertical direction, in the in-vehicle state of being mounted on the electric vehicle 100.

In the vehicle driving device A of the present embodiment, at least part of the inverter C is disposed in the upper region E3, and the power conversion device B is disposed in a region extending below the inverter C in the side region E4.

That is, in the present embodiment, when the inverter C is in the horizontal posture when viewed in the axial direction L (in side view), the power conversion device B extends in the vertical direction along the vertical direction Z, whereby the inverter C and the power conversion device B are formed in an "inverted L" shape. That is, the inverter C is disposed in a horizontal posture above the traveling motor M in a region extending in the axial orthogonal direction Y in the upper region E3 of the second accommodation chamber E2, and the power conversion device B is disposed in a vertical posture in the side region E4 adjacent to the upper region E3 and extending in the vertical direction. Instead of the arrangement of the present embodiment, the power conversion device B may be disposed in the upper region E3, and the inverter C may be disposed in the side region E4. According to the arrangement of the present embodiment, the inverter C and the power conversion device B can be disposed by effectively using the upper region E3 above the motor M and the side region E4 adjacent to the motor M in the axial orthogonal direction Y

In the another embodiment (e), a direction opposite to the first axial orthogonal direction Y1 is referred to as a second axial orthogonal direction Y2, and either the first axial orthogonal direction Y1 or the second axial orthogonal direction Y2 may be the front side of the vehicle body of the electric vehicle 100.

In the above-described embodiment, the following configuration is conceived.
[1] An aspect of the electronic component cooling structure is an electronic component cooling structure in which a plurality of cooling plates (11, 12) each having a cooling fluid flow path (R) therein is disposed in a stacked manner, a cooling liquid for cooling the electronic components (15, 16, 21, 22, 66, T) flowing through the cooling fluid flow path, wherein the electronic components (15, 16, 21, 22, 66, T) are disposed at both sides of each of the plurality of cooling plates (11, 12), the electronic components facing the cooling plates, and wherein the electronic components (15, 16, 21, 22, 66, T) are cooled via the facing cooling plates (11, 12).
   In the electronic component cooling structure according to the present aspect, since the plurality of cooling plates (11, 12) is disposed, the degree of freedom of arrangement of the plurality of electronic components (15, 16, 21, 22, 66, T) can be increased by disposing the plurality of cooling plates (11, 12) as long as the area of the cooling plates is the same, compared with the configuration in which only one cooling plate is disposed. A plurality of electronic components (15, 16, 21, 22, 66, T) is disposed at both sides of each of the plurality of cooling plates (11, 12), the electronic components facing the cooling plates, and the electronic components (15, 16, 21, 22, 66, T) are cooled via the facing cooling plates (11, 12). Therefore, the cooling area of the cooling plate can be doubled, compared with the case where the electronic component is cooled using only one face of the cooling plate. Therefore, the plurality of electronic components (15, 16, 21, 22, 66, T) can be cooled in a space-saving manner.
[2] In the electronic component cooling structure according to [1], the electronic components (15, 16, 21, 22, 66, T) and the plurality of cooling plates (11, 12) are preferably built in the electric vehicle (100).
   According to this configuration, the electronic components (15, 16, 21, 22, 66, T) incorporated in the electric vehicle (100) can be efficiently cooled by the plurality of cooling plates (11, 12).
[3] In the electronic component cooling structure according to [2], the plurality of cooling plates (11, 12) is preferably disposed in a stacked manner.
   According to this configuration, since the plurality of cooling plates (11, 12) is disposed in a stacked manner, the device incorporating the cooling plates can be downsized by disposing the plurality of cooling plates (11, 12) in a stacked manner as long as the area of the cooling plates is the same, compared with the configuration in which only one cooling plate is disposed.
[4] In the electronic component cooling structure according to [3], the electronic components (15, 16, T) disposed between the adjacent cooling plates (11, 12) among the plurality of cooling plates (11, 12) are preferably cooled any of the adjacent cooling plates (11, 12).
   According to this configuration, since the inter-plate electronic components (15, 16, T) including the electronic component disposed between the adjacent cooling plates (11, 12) are cooled any of the adjacent cooling plates (11, 12), the inter-plate electronic components (15, 16, T) can be cooled by efficiently utilizing the space between the adjacent cooling plates (11, 12).
[5] In the electronic component cooling structure according to [4], the inter-plate electronic component (16) preferably has relatively lower heat resistance than another electronic component.
   According to this configuration, by disposing electronic component (16) having relatively low heat resistance between the adjacent cooling plates (11, 12), even when an electronic component having a large amount of heat generation is disposed outside the adjacent cooling plates (11, 12), heat transfer to the electronic component (16) having relatively low heat resistance can be suppressed by the cooling plates (11, 12).
[6] In the electronic component cooling structure according to [4] or [5], it is preferable that the frame member (18) covering at least part of a side face of the inter-plate electronic components (15, 16, T) is disposed between the adjacent cooling plates (11, 12), and the frame member (18) includes the communication passage (13) communicating with the cooling fluid flow path (flow path R) of each of the plurality of cooling plates (11, 12).
   According to this configuration, since the frame member (18) has the communication passage (13) through which the cooling fluid flows, the cooling fluid flowing through the communication passage (13) cools the frame member (18), whereby the inter-plate electronic components (15, 16, T) covered by the frame member (18) can be indirectly cooled. Accordingly, the inter-plate electronic components (15, 16, T) can be efficiently cooled from the upper face, the lower face, and the side face.
[7] In the electronic component cooling structure according to [6], it is preferable that the frame member (18) includes a plurality of wall portions (18a) overlapping at least part of the inter-plate electronic components (15, 16, T) in the direction orthogonal to the stacking direction of the cooling plates (11, 12), and at least one of the wall portions (18a) is connected to the communication passage (13).
   According to this configuration, the wall portion (18a1) connected to the communication passage (13) is easily cooled by the cooling fluid, and hence the frame member (18) can be cooled via the wall portion (18a1). Accordingly, the inter-plate electronic components (15, 16, T) located in the vicinity of the frame member (18) can be efficiently cooled.
[8] In the electronic component cooling structure according to [6] or [7], it is preferable that the frame member (18) includes a plurality of protrusions (18c) protruding from the cooling plate (12) along the stacking direction and facing the adjacent cooling plate (11), and a cross-sectional area, in a direction orthogonal to the stacking direction, of the protrusion (18c1) located in the vicinity of the electronic component (switching element 15) having a relatively large amount of heat generation and the board wiring generating heat by an energization current is larger than a cross-sectional area of the protrusions (18c) in another place.
   According to this configuration, the contact area between the cooling plate (11) and the upper face of the protrusion (18c1) located in the vicinity of the electronic component (switching element 15) having a relatively large amount of heat generation and the board wiring that generates heat by an energization current can be improved, so that the protrusion (18c1) can be indirectly cooled. Accordingly, it is possible to indirectly cool the electronic component (switching element 15) having a large amount of current and a relatively large amount of heat generation and the board wiring that generates heat by an energization current via the frame member (18). Accordingly, not only the cooling plate (11) but also the frame member (18) can cool the electronic component (switching element 15) having a relatively large amount of heat generation and the board wiring that generates heat by an energization current, whereby the electronic component and the board wiring can be efficiently cooled.
[9] In the electronic component cooling structure according to [8], the electronic component having a relatively large amount of heat generation includes preferably the switching element (15) of the on-board charger (50) that charges the batteries (BAT1, BAT2) of the electric vehicle (100) and the board wiring that generates heat by an energization current.
   According to this configuration, the switching element (15) having a large amount of current and a relatively large amount of heat generation and the board wiring generating heat by an energization current can be indirectly cooled via the frame member (18). Accordingly, the switching element (15) and the board wiring that generates heat by an energization current can be cooled by the frame member (18) in addition to the cooling plate (11), so that the cooling can efficiently be performed.
[10] In the electronic component cooling structure according to [3], it is preferable that the plurality of cooling plates (11, 12) includes the first cooling plate (11) and the second cooling plate (12), the first cooling plate (11) and the second cooling plate (12) are disposed in this order from a top along the vertical direction, and the drive circuit (66) that drives the motor (M) serving as a traveling power source of the electric vehicle (100) is disposed as an electronic component on the upper face (11a) of the first cooling plate (11).
   In general, the drive circuit (66) that drives the motor (M) serving as a traveling power source of the electric vehicle (100) has a large amount of heat generation. Therefore, by disposing the drive circuit (66) on the upper face (11a) of the first cooling plate (11), heat of the drive circuit (66) transmitted to other electronic components can be suppressed, and the drive circuit (66) can be efficiently cooled by the first cooling plate (11).
[11] In the electronic component cooling structure according to [10], the switching element (15) of the on-board charger (50) that charges the batteries (BAT1, BAT2) of the electric vehicle (100) is preferably disposed as an electronic component on the lower face (11b) of the first cooling plate (11).
   According to this configuration, the switching element (15) of the on-board charger (50) can be efficiently cooled by the first cooling plate (11). By disposing the switching element (15) of the on-board charger (50) on the lower face (11b) of the first cooling plate (11), the electrical wiring to the control circuit can be shortened.
[12] In the electronic component cooling structure according to [10] or [11], the transformer (T) and the bulk capacitor (16) are preferably disposed as electronic components on the upper face (12a) of the second cooling plate (12).
   According to this configuration, the transformer (T) and the bulk capacitor (16) can be efficiently cooled by the second cooling plate (12). Specifically, since the bulk capacitor (16) has relatively low heat resistance, even when an electronic component having a large amount of heat generation is disposed outside the adjacent cooling plates (11, 12), the cooling plates (11, 12) can suppress transfer of heat to the bulk capacitor (16) which is an electronic component having relatively low heat resistance.
[13] In the electronic component cooling structure according to [10] or [11], the filter substrate (22) and the coil module (21) are preferably disposed as electronic components (21, 22) on the lower face (12b) of the second cooling plate (12).
   According to this configuration, the filter substrate (22) and the coil module (21) can be efficiently cooled by the second cooling plate (12). Further, by disposing the filter substrate (22) and the coil module (21) having a large weight on the lower side, the weight balance is stabilized.
[14] In the electronic component cooling structure according to [3], it is preferable that the plurality of cooling plates (11, 12) includes the first cooling plate (11) and the second cooling plate (12), the first cooling plate (11) and the second cooling plate (12) are disposed in this order from a top along the vertical direction, and the filter substrate (22) and the coil module (21) are disposed as electronic components on the upper face (11a) of the first cooling plate (11).
   According to this configuration, the filter substrate (22) and the coil module (21) can be efficiently cooled by the first cooling plate (11).
[15] In the electronic component cooling structure according to [14], the transformer (T) and the bulk capacitor (16) are preferably disposed as electronic components on the lower face (11b) of the first cooling plate (11).
   According to this configuration, the transformer (T) and the bulk capacitor (16) can be efficiently cooled by the first cooling plate (11). Specifically, since the bulk capacitor (16) has relatively low heat resistance, even when an electronic component having a large amount of heat generation is disposed outside the adjacent cooling plates (11, 12), the cooling plates (11, 12) can suppress transfer of heat to the bulk capacitor (16) which is an electronic component having relatively low heat resistance.
[16] In the electronic component cooling structure according to [14] or [15], the switching element (15) of the on-board charger (50) that charges the batteries (BAT1, BAT2) of the electric vehicle (100) is preferably disposed as an electronic component on the upper face (12a) of the second cooling plate (12).
   According to this configuration, the switching element (15) of the on-board charger (50) can be efficiently cooled by the second cooling plate (12). By disposing the switching element (15) of the on-board charger (50) on the upper face (12a) of the second cooling plate (12), the electrical wiring to the control circuit can be shortened.
[17] In the electronic component cooling structure according to [14] or [15], the drive circuit (66) that drives the motor (M) serving as a traveling power source of the electric vehicle (100) is preferably disposed as an electronic component on the lower face (12b) of the second cooling plate (12).

In general, the drive circuit (66) that drives the motor (M) serving as a traveling power source of the electric vehicle (100) has a large amount of heat generation. Therefore, by disposing the drive circuit (66) on the lower face (12b) of the second cooling plate (12), heat of the drive circuit (66) transmitted to other electronic components can be suppressed, and the drive circuit (66) can be efficiently cooled by the second cooling plate (12).

The present disclosure can be used in an electronic component cooling structure and a vehicle driving device.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. An electronic component cooling structure in which a plurality of cooling plates (11, 12) each having a cooling fluid flow path (R) therein is disposed, cooling fluid for cooling an electronic components (15, 16, 21, 22, 66, T) flowing through the cooling fluid flow path (R), wherein
the electronic components (15, 16, 21, 22, 66, T) are disposed at both sides of each of the plurality of cooling plates (11, 12), the electronic components (15, 16, 21, 22, 66, T) facing the cooling plates (11, 12), and wherein
the electronic components (15, 16, 21, 22, 66, T) are cooled via the facing cooling plates (11, 12).

2. The electronic component cooling structure according to claim 1, wherein the electronic components (15, 16, 21, 22, 66, T) and the plurality of cooling plates (11, 12) are built in an electric vehicle (100).

3. The electronic component cooling structure according to claim 1 or 2, wherein the plurality of cooling plates (11, 12) is disposed in a stacked manner.

4. The electronic component cooling structure according to any one of claims 1 to 3, wherein an inter-plate electronic component (15, 16, T) including the electronic component disposed between adjacent cooling plates (11, 12) among the plurality of cooling plates (11, 12) is cooled by any of the adjacent cooling plates (11, 12).

5. The electronic component cooling structure according to claim 4, wherein the inter-plate electronic component (16) has relatively lower heat resistance than another electronic component.

6. The electronic component cooling structure according to claim 4 or 5, wherein
a frame member (18) that covers at least part of a side face of the inter-plate electronic component (15, 16, T) is disposed between the adjacent cooling plates (11, 12), and wherein
the frame member (18) includes a communication passage (13) communicating with the cooling fluid flow path (R) of each of the plurality of cooling plates (11, 12).

7. The electronic component cooling structure according to claim 6, wherein
the frame member (18) includes a plurality of wall portions (18a) overlapping at least part of the inter-plate electronic component (15, 16, T) in a direction orthogonal to a stacking direction of the cooling plates (11, 12), and wherein
at least one of the wall portions (18a) is connected to the communication passage (13).

8. The electronic component cooling structure according to claim 6 or 7, wherein
the frame member (18) includes a plurality of protrusions (18c) protruding from the cooling plate (12) along a stacking direction of the cooling plate (12) and facing an adjacent cooling plate (11), and wherein
a cross-sectional area, in a direction orthogonal to the stacking direction, of a protrusion (18c1) located in the vicinity of an electronic component having a relatively large amount of heat generation and board wiring that generates heat by an energization current is larger than a cross-sectional area of a protrusion (18c) at another location.

9. The electronic component cooling structure according to claim 8, wherein the electronic component having a relatively large amount of heat generation and the board wiring are switching elements (15) of an on-board charger (50) that charges a battery (BAT1, BAT2) of the electric vehicle (100).

10. The electronic component cooling structure according to any one of claims 1 to 3, wherein
the plurality of cooling plates (11, 12) includes a first cooling plate (11) and a second cooling plate (12), wherein
the first cooling plate (11) and the second cooling plate (12) are disposed in this order from a top along a vertical direction, and wherein
a drive circuit (66) that drives a motor (M) serving as a traveling power source of the electric vehicle (100) is disposed as the electronic component at an upper face (11a) of the first cooling plate (11).

11. The electronic component cooling structure according to claim 10, wherein a switching element (15) of an on-board charger (50) that charges a battery (BAT1, BAT2) of the electric vehicle (100) is disposed as the electronic component at a lower face (11b) of the first cooling plate (11).

12. The electronic component cooling structure according to claim 10 or 11, wherein a transformer (T) and a bulk capacitor (16) are disposed as the electronic component at an upper face (12a) of the second cooling plate (12).

13. The electronic component cooling structure according to claim 10 or 11, wherein a filter substrate (22) and a coil module (21) are disposed as the electronic components (21, 22) at a lower face (12b) of the second cooling plate (12).

14. The electronic component cooling structure according to any one of claims 1 to 3, wherein
the plurality of cooling plates (11, 12) includes a first cooling plate (11) and a second cooling plate (12), wherein
the first cooling plate (11) and the second cooling plate (12) are disposed in this order from a top along a vertical direction, and wherein
a filter substrate (22) and a coil module (21) are disposed as the electronic component at an upper face (11a) of the first cooling plate (11).

15. The electronic component cooling structure according to claim 14, wherein a transformer (T) and a bulk capacitor (16) are disposed as the electronic components at a lower face (11b) of the first cooling plate (11).

16. The electronic component cooling structure according to claim 14 or 15, wherein a switching element (15) of an on-board charger (50) that charges a battery (BAT1, BAT2) of the electric vehicle (100) is disposed as the electronic component at an upper face (12a) of the second cooling plate (12).

17. The electronic component cooling structure according to any one of claims 14 to 16, wherein a drive circuit (66) that drives a motor (M) serving as a traveling power source of the electric vehicle (100) is disposed as the electronic component at a lower face (12b) of the second cooling plate (12).
